# EUROPEAN PATENT APPLICATION

(11) **EP 4 601 431 A1**
(43) Date of publication of application: **13.08.2025**
(21) Application number: 24217246.8
(22) Date of filing: 03.12.2024
(51) Int. Cl.: H10B 12/00, H10B 53/10, H10B 53/30, H10D 1/68

(54) **SEMICONDUCTOR DEVICE**

(30) Priority: 06.02.2024 KR 20240018171
(71) Applicant: Samsung Electronics Co., Ltd., Suwon-si, Gyeonggi-do 16677 (KR)
(72) Inventor: BAEK, Dongkwan, 16677 Suwon-si (KR); CHANG, Jaewan, 16677 Suwon-si (KR); CHO, Chunhum, 16677 Suwon-si (KR)
(74) Representative: Marks & Clerk LLP

(57) **Abstract**

A semiconductor device includes bottom (BE) and top (TE) electrodes and a dielectric layer (DL) and a material layer (ML1, ML2) between the bottom and top electrodes. The dielectric layer includes first (DL1), second (DL2), and third (DL3) metal oxide layers. The third metal oxide layer includes a compound represented by AₓB₁₋ₓO₂, where A and B are different and are chosen from the group consisting of zirconium (Zr), hafnium (Hf), titanium (Ti), niobium (Nb), tantalum (Ta), strontium (Sr), and barium (Ba). The material layer includes one of a metal material containing a metal element, an oxide material containing the metal element, and an oxynitride material containing the metal element, and the metal element includes at least one of scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), tin (Sn), platinum (Pt), and lanthanum (La).

## Description

### BACKGROUND OF THE INVENTION

The present disclosure relates to a semiconductor device, and in particular, to a semiconductor device including a capacitor structure.

Due to their small-sized, multifunctional, and/or low-cost characteristics, semiconductor devices are being esteemed as important elements in the electronic industry. The semiconductor devices may be classified into a semiconductor memory device for storing data, a semiconductor logic device for processing data, and a hybrid semiconductor device including both of memory and logic elements.

As integration densities of the semiconductor devices increase, it is necessary to realize a capacitor having sufficiently high capacitance in a limited area. The capacitance of the capacitor varies in proportion to the surface area of an electrode and the dielectric constant of a dielectric layer, and inversely with the equivalent oxide thickness of the dielectric layer. Recently, various studies are being conducted to increase the capacitance of the capacitor.

### SUMMARY

An embodiment of the inventive concept provides a semiconductor device including a capacitor with an increased electrostatic capacitance.

An embodiment of the inventive concept provides a semiconductor device including a capacitor with a reduced leakage current.

According to an embodiment of the inventive concept, a semiconductor device may include a bottom electrode, a top electrode on the bottom electrode, and a dielectric layer and a material layer interposed between the bottom electrode and the top electrode. The dielectric layer may include a first metal oxide layer, a second metal oxide layer on the first metal oxide layer, and a third metal oxide layer interposed between the first and second metal oxide layers. The third metal oxide layer may include a compound represented by a chemical formula of AₓB₁₋ₓO₂, where A and B are two different elements, which are chosen from the group consisting of zirconium (Zr), hafnium (Hf), titanium (Ti), niobium (Nb), tantalum (Ta), strontium (Sr), and barium (Ba), and where 0 < x < 1. The material layer may include one of a metal material containing a metal element, an oxide material containing the metal element, and an oxynitride material containing the metal element, and the metal element may include at least one of scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), tin (Sn), platinum (Pt), and lanthanum (La).

According to an embodiment of the inventive concept, a semiconductor device may include a bottom electrode, a top electrode on the bottom electrode, and a dielectric layer and a material layer interposed between the bottom electrode and the top electrode. The dielectric layer may include a first metal oxide layer, a second metal oxide layer on the first metal oxide layer, and a third metal oxide layer interposed between the first and second metal oxide layers. The first and second metal oxide layers may include zirconium oxide, and the third metal oxide layer may include hafnium-zirconium oxide. A thickness of the third metal oxide layer may be 30 % to 50 % of a thickness of the dielectric layer.

According to an embodiment of the inventive concept, a semiconductor device may include a substrate, conductive contacts on the substrate, bottom electrodes on the conductive contacts, a top electrode on the bottom electrodes, and a dielectric layer and a material layer between the bottom electrodes and the top electrode. The dielectric layer may include a first metal oxide layer, a second metal oxide layer on the first metal oxide layer, and a third metal oxide layer on the second metal oxide layer. The first and third metal oxide layers may include zirconium oxide, and the second metal oxide layer may include hafnium-zirconium oxide. The material layer may include one of a metal material containing a metal element, an oxide material containing the metal element, and an oxynitride material containing the metal element. The metal element may include at least one of scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), tin (Sn), platinum (Pt), and lanthanum (La). The first and third metal oxide layers may include a tetragonal crystal phase and the second metal oxide layer may include the tetragonal crystal phase and an orthorhombic crystal phase.

At least some of the above and other features of the invention are set out in the claims.

### BRIEF DESCRIPTION OF THE DRAWINGS

FIG. 1A is a sectional view illustrating a capacitor structure of a semiconductor device according to an example embodiment of the inventive concept.
FIG. 1B is a sectional view illustrating a capacitor structure of a semiconductor device according to an example embodiment of the inventive concept.
FIG. 1C is a sectional view illustrating a capacitor structure of a semiconductor device according to an example embodiment of the inventive concept.
FIG. 2 is a plan view illustrating a semiconductor device according to an example embodiment of the inventive concept.
FIGS. 3A to 3C are sectional views, which are taken along a line A-A' of FIG. 2, to illustrate the semiconductor device according to an example embodiment of the inventive concept.
FIG. 4 is a plan view illustrating a semiconductor device according to an example embodiment of the inventive concept.
FIGS. 5 and 6 are sectional views taken along lines B-B' and C-C' of FIG. 4.
FIG. 7 is an enlarged sectional view illustrating a portion (e.g., CU of FIG. 5) of the semiconductor device according to an example embodiment of the inventive concept.

### DETAILED DESCRIPTION

Example embodiments of the inventive concepts will now be described more fully with reference to the accompanying drawings, in which example embodiments are shown. Like reference characters refer to like elements throughout.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Terms such as "same," "equal," "planar," or "coplanar," as used herein when referring to orientation, layout, location, shapes, sizes, amounts, or other measures do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise.

### [EMBODIMENT 1]

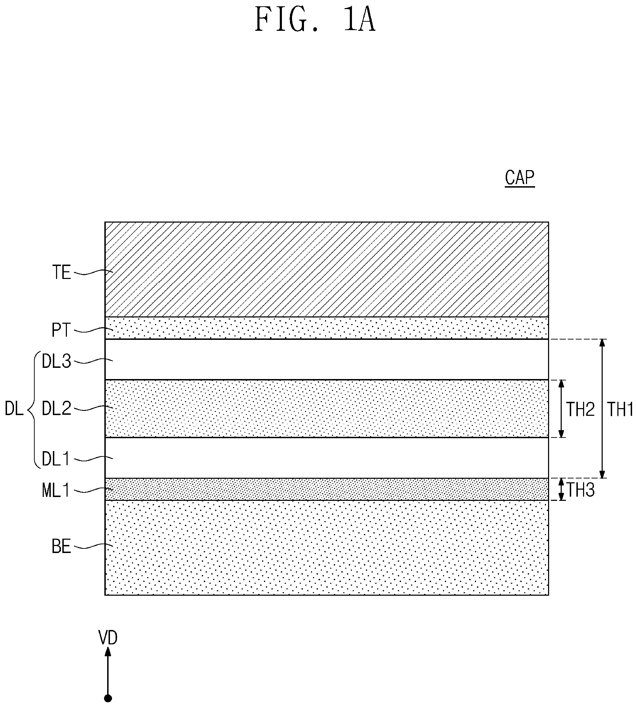

FIG. 1A is a sectional view illustrating a capacitor structure of a semiconductor device according to the example embodiment 1 of the inventive concept.

Referring to FIG. 1A, the semiconductor device may include a capacitor structure CAP. In an embodiment, the capacitor structure CAP may be used as a data storing element, allowing the semiconductor device to serve as a memory device. The capacitor structure CAP may include a bottom electrode BE, a dielectric layer DL, and a top electrode TE, which are sequentially provided in a vertical direction VD. The vertical direction VD may be a direction that is normal to a top surface of the bottom or top electrode BE or TE. The dielectric layer DL may be interposed between the bottom electrode BE and the top electrode TE. Each of the bottom and top electrodes BE and TE may be formed of or include at least one of vanadium nitride (VN), titanium nitride (TiN), niobium nitride (NbN), molybdenum nitride (MoN), tantalum nitride (TaN), ruthenium (Ru), ruthenium oxide (RuO₂), platinum (Pt), iridium (Ir), strontium ruthenate (SrRuO₃), tungsten (W), or tungsten nitride (WN). Each of the bottom and top electrodes BE and TE may be a single layer, which is made of a single material, or a composite layer including two or more materials.

The dielectric layer DL may include a first metal oxide layer DL1, a second metal oxide layer DL2, and a third metal oxide layer DL3, which are sequentially disposed on the bottom electrode BE in the vertical direction VD. In other words, the second metal oxide layer DL2 may be interposed between the first and third metal oxide layers DL1 and DL3. In example embodiments, a bottom surface of the third metal oxide layer DL3 may contact a top surface of the second metal oxide layer DL2, and a bottom surface of the second metal oxide layer DL2 may contact a top surface of the first metal oxide layer DL1.

The first and third metal oxide layers DL1 and DL3 may include the same material or may include different materials from each other. The first and third metal oxide layers DL1 and DL3 may include a material, which is formed of at least one element of zirconium (Zr), titanium (Ti), niobium (Nb), tantalum (Ta), strontium (Sr), or barium (Ba), and an oxide material containing the element. As an example, the first and third metal oxide layers DL1 and DL3 may include zirconium oxide. In an embodiment, the first and third metal oxide layers DL1 and DL3 may include zirconium oxide that is doped with at least one of aluminum (AI), yttrium (Y), vanadium (V), or silicon (Si).

The second metal oxide layer DL2 may include a material that is different from the first and third metal oxide layers DL1 and DL3. The second metal oxide layer DL2 may have the chemical formula of AₓB_{1-X}O₂, where A and B are two different elements, which are chosen from the group consisting of zirconium (Zr), hafnium (Hf), titanium (Ti), niobium (Nb), tantalum (Ta), strontium (Sr), and barium (Ba), and 0 < x < 1. The concentration of the element A in the second metal oxide layer DL2 may range from 20 at% to 80 at%. In an embodiment, the second metal oxide layer DL2 may have a chemical formula of Hf_{X}Zr₁₋ₓO₂, and here, in the second metal oxide layer DL2, the concentration of zirconium (Zr) may be higher than the concentration of hafnium (Hf).

In an embodiment, the first and third metal oxide layers DL1 and DL3 may have a tetragonal crystal phase. When discussing crystal phases, these phases may be the phases of the respective materials at room temperature (e.g. 20°C). The second metal oxide layer DL2 may have both of tetragonal and orthorhombic crystal phases. That is, the second metal oxide layer DL2 may include one or more portions that have a tetragonal crystal structure, and one or more portions that have an orthorhombic crystal structure. Given this, the second metal oxide layer DL2 may have a composition at a morphotropic phase boundary (e.g. at a morphotropic phase boundary at room temperature (e.g. 20°C)).

The dielectric layer DL may have a first thickness TH1. The second metal oxide layer DL2 of the dielectric layer DL may have a second thickness TH2. The second thickness TH2 may be 30 % to 50 % of the first thickness TH1. In an embodiment, the first thickness TH1 may range from 20 Å to 80 Å. The second thickness TH2 may range from 6 Å to 40 Å.

A first material layer ML1 may be interposed between the bottom electrode BE and the dielectric layer DL. For example, the first material layer ML1 may be in contact with a top surface of the bottom electrode BE and a bottom surface of the dielectric layer DL. The first material layer ML1 may include one of a metal material containing a metal element, an oxide material containing the metal element, and an oxynitride material containing the metal element. The metal element may include at least one of scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), tin (Sn), platinum (Pt), or lanthanum (La). Here, a concentration of the metal material in the first material layer ML1 may range from 0 at % to 30 at %. In addition, the first material layer ML1 may further include an oxide material, which contains an element included in the bottom electrode BE. The first material layer ML1 may have a third thickness TH3. In an embodiment, the third thickness TH3 may range from 1 Å to 5 Å.

A capping layer PT may be interposed between the dielectric layer DL and the top electrode TE. In example embodiments, the capping layer PT may contact a top surface of the third metal oxide layer DL3 and a bottom surface of the top electrode TE. The capping layer PT may include at least one of silicon (Si), boron (B), lithium (Li), scandium (Sc), aluminum (Al), yttrium (Y), niobium (Nb), tantalum (Ta), titanium (Ti), molybdenum (Mo), or lanthanum (La). In an embodiment, the capping layer PT may be omitted. In the case where the capping layer PT is omitted, the third metal oxide layer DL3 of the dielectric layer DL may be in contact with the top electrode TE.

### [EMBODIMENT 2]

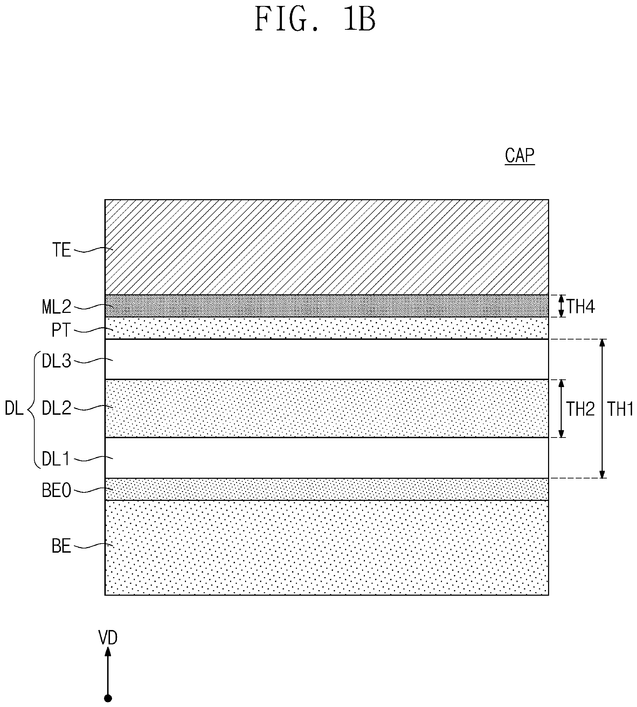

FIG. 1B is a sectional view illustrating a capacitor structure of a semiconductor device according to the example embodiment 2 of the inventive concept. For concise description, an element previously described with reference to FIG. 1A may be identified by the same reference number without repeating an overlapping description thereof.

Referring to FIG. 1B, an oxide layer BEO may be interposed between the dielectric layer DL and the bottom electrode BE. In example embodiments, the oxide layer BEO may contact a bottom surface of the dielectric layer DL and a top surface of the bottom electrode BE. That is, in the capacitor structure CAP of FIG. 1B, the oxide layer BEO, instead of the first material layer ML1, may be disposed on the bottom electrode BE, unlike the capacitor structure of FIG. 1A. The oxide layer BEO may include an oxide material, which contains an element included in the bottom electrode BE.

A second material layer ML2 may be interposed between the top electrode TE and the dielectric layer DL. In example embodiments, the second material layer ML2 may contact a top surface of the dielectric layer DL and a bottom surface of the dielectric layer DL. In other example embodiments, the second material layer ML2 may contact a top surface of the capping layer PT and a bottom surface of the top electrode TE. The second material layer ML2 may include one of a metal material containing a metal element, an oxide material containing the metal element, and an oxynitride material containing the metal element, and the metal element may include at least one of scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), tin (Sn), platinum (Pt), or lanthanum (La). Here, a concentration of the metal material in the second material layer ML2 may range from 0 at % to 30 at %. The second material layer ML2 may have a fourth thickness TH4. The fourth thickness TH4 may range from 1 Å to 5 Å.

The capping layer PT may be interposed between the dielectric layer DL and the second material layer ML2. That is, the capping layer PT may be spaced apart from the top electrode TE, unlike the embodiment 1. In the case where the capping layer PT is omitted, the third metal oxide layer DL3 of the dielectric layer DL may be in contact with the top electrode TE.

### [EMBODIMENT 3]

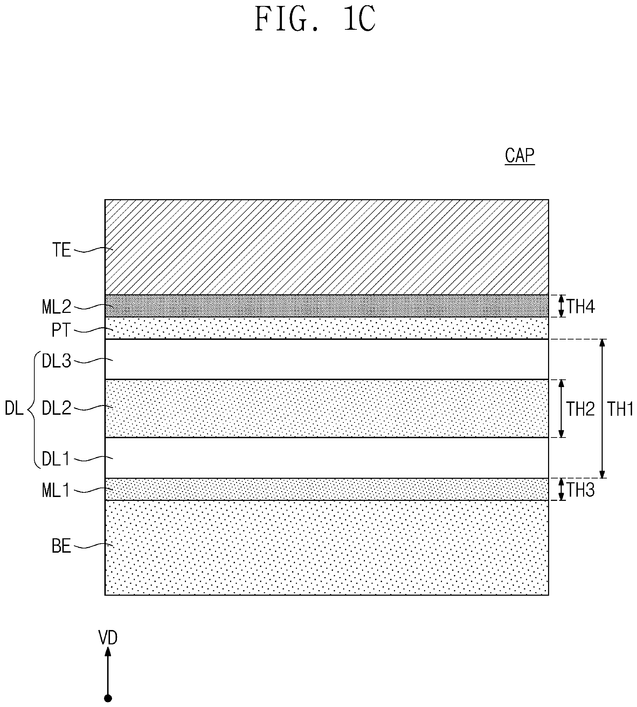

FIG. 1C is a sectional view illustrating a capacitor structure of a semiconductor device according to the example embodiment 3 of the inventive concept. An element previously described with reference to FIGS. 1A and 1B may be identified by the same reference number without repeating an overlapping description thereof.

Referring to FIG. 1C, the first material layer ML1 may be interposed between the bottom electrode BE and the dielectric layer DL. The second material layer ML2 may be interposed between the top electrode TE and the dielectric layer DL. That is, the capacitor structure CAP in the embodiment 3 may include both of the first and second material layers ML1 and ML2, unlike the capacitor structures CAP in the embodiments 1 and 2. The first and second material layers ML1 and ML2 may be configured to have substantially the same features as those in the embodiments described with reference to FIGS. 1A and 1B. More generally, the embodiments described herein may comprise one or more material layers. The one or more material layers may comprise one or both of the first material layer and the second material layer.

### [FABRICATION METHOD : EMBODIMENT 1]

Hereinafter, a method of fabricating the capacitor structure according to the embodiment 1 will be described in more detail.

Referring to the embodiment 1, an oxide layer (not shown) may be formed on the bottom electrode BE. The oxide layer may be a layer that is formed when a material in the bottom electrode BE is oxidized through a natural oxidation process.

A preliminary first material layer (not shown) may be deposited on the oxide layer. The preliminary first material layer may include one of a metal material containing a metal element, an oxide material containing the metal element, and an oxynitride material containing the metal element. The metal element may include at least one of scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), tin (Sn), platinum (Pt), or lanthanum (La).

A thermal treatment process may be performed on the preliminary first material layer, and in this case, a material in the preliminary first material layer may be diffused into the bottom electrode BE and the oxide layer. As a result of the process, the bottom electrode BE and the oxide layer may be doped with the material included in the preliminary first material layer. As a result of the doping process, the first material layer ML1 may be formed from the bottom electrode BE and the oxide layer. Next, a selective etching process may be performed to remove the preliminary first material layer and to leave only the first material layer ML1 on the bottom electrode BE. In an embodiment, a thermal treatment process may be performed on the first material layer ML1.

Next, the first, second, and third metal oxide layers DL1, DL2, and DL3 of the dielectric layer DL may be sequentially formed on the first material layer ML1. The first, second, and third metal oxide layers DL1, DL2, and DL3 of the dielectric layer DL may be formed through an atomic layer deposition (ALD) process.

Here, the second metal oxide layer DL2 of the dielectric layer DL may be formed of a material that can be written by the chemical formula of AₓB_{1-X}O₂. Here, the elements A and B are two different elements, which are chosen from the group consisting of zirconium (Zr), hafnium (Hf), titanium (Ti), niobium (Nb), tantalum (Ta), strontium (Sr), and barium (Ba). That is, the elements A and B are different elements from each other, and here, 0 < x < 1. The concentration of the element A in the second metal oxide layer DL2 may range from 20 at% to 80 at%.

In an embodiment, the concentration of the element A in the second metal oxide layer DL2 may be adjusted by forming an oxide material containing the element A between oxide materials containing the element B and performing a thermal treatment process to cause the diffusion of the element A. In an embodiment, the concentration of the element A may be adjusted by providing a cocktail precursor containing the elements A and B on the first metal oxide layer DL 1. In an embodiment, the concentration of the element A may be adjusted by simultaneously or alternately providing a precursor containing the element A and a precursor containing the element B on the first metal oxide layer DL 1.

Next, the capacitor structure CAP of FIG. 1A may be fabricated by forming the top electrode TE on the dielectric layer DL. Optionally, the capping layer PT may be formed on the dielectric layer DL before forming the top electrode TE on the capping layer PT.

### [FABRICATION METHOD : EMBODIMENT 2]

Hereinafter, a method of fabricating the capacitor structure according to the embodiment 2 will be described in more detail. In the following description of the fabrication method in the embodiment 2, the features overlap with the embodiment 1 will be omitted.

Referring to the embodiment 2, the oxide layer BEO may be formed on the bottom electrode BE. The oxide layer BEO may be a layer that is formed when a material in the bottom electrode BE is oxidized through a natural oxidation process. The dielectric layer DL may be formed on the oxide layer BEO. The dielectric layer DL may be formed in the same or similar manner as described with reference to FIG. 1A. The capping layer PT may be formed on the dielectric layer DL, or may be omitted.

Next, the second material layer ML2 may be formed on the dielectric layer DL (or on the capping layer PT). The second material layer ML2 may include one of a metal material containing a metal element, an oxide material containing the metal element, and an oxynitride material containing the metal element. The metal element may include at least one of scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), tin (Sn), platinum (Pt), or lanthanum (La).

Next, the top electrode TE may be formed on the second material layer ML2 to fabricate the capacitor structure CAP of FIG. 1B.

### [FABRICATION METHOD : EMBODIMENT 3]

Hereinafter, a method of fabricating the capacitor structure according to the embodiment 3 will be described in more detail. In the following description of the fabrication method in the embodiment 3, the features overlap with the embodiments 1 and 2 will be omitted.

Referring to the embodiment 3, the first material layer ML1 and the dielectric layer DL may be formed on the bottom electrode BE. The first material layer ML1 and the dielectric layer DL may be formed in the same or similar manner as described with reference to FIG. 1A.

The capping layer PT may be formed on the dielectric layer DL, or may be omitted. The second material layer ML2 may be formed on the dielectric layer DL (or on the capping layer PT). The second material layer ML2 may be formed in the same or similar manner as that in the embodiment 2. Next, the capacitor structure CAP in the embodiment 3 may be fabricated by forming the top electrode TE on the second material layer ML2.

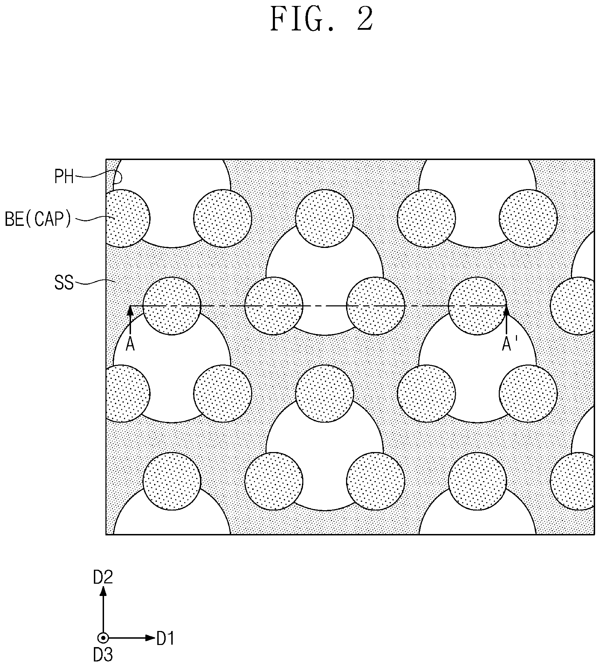

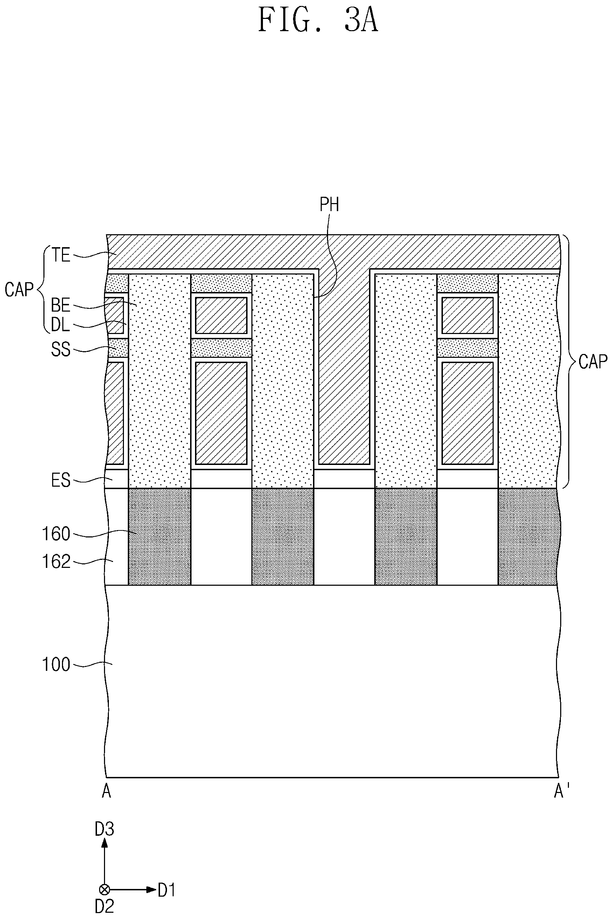

FIG. 2 is a plan view illustrating a semiconductor device according to an example embodiment of the inventive concept. FIG. 3A is a sectional view taken along a line A-A' of FIG. 2.

Referring to FIGS. 2 and 3A, a substrate 100 may be provided. The substrate 100 may be a semiconductor substrate. For example, the substrate 100 may be a silicon substrate, a germanium substrate, or a silicon-germanium substrate.

An interlayer insulating layer 162 may be disposed on the substrate 100. The interlayer insulating layer 162 may cover at least a portion of a top surface of the substrate 100. The interlayer insulating layer 162 may contact at least a portion of the top surface of the substrate 100. In an embodiment, the interlayer insulating layer 162 may be formed of or include at least one of silicon nitride, silicon oxide, or silicon oxynitride. In an embodiment, the interlayer insulating layer 162 may include an empty region (e.g., an air gap).

A conductive contact 160 may be disposed in the interlayer insulating layer 162. The conductive contact 160 may contact the top surface of the substrate 100. The interlayer insulating layer 162 may contact a side surface of the conductive contact 160. Top surfaces of the conductive contact 160 and the interlayer insulating layer 162 may be coplanar. In an embodiment, a plurality of conductive contacts 160 may be provided to be spaced apart from each other in a first direction D1 and a second direction D2.

In the present specification, the first direction D1 may be defined to be parallel to the top surface of the substrate 100. The second direction D2 may be defined as a direction that is parallel to the top surface of the substrate 100 and is perpendicular to the first direction D1. A third direction D3 may be defined as a direction that is perpendicular to the top surface of the substrate 100.

The conductive contact 160 may be formed of or include at least one of doped semiconductor materials (e.g., poly silicon), metallic materials (e.g., Ti, Mo, W, Cu, Al, Ta, Ru, Ir, Co, Pt, Au, and Ag), metal nitride materials (e.g., nitride materials of Ti, Mo, W, Cu, Al, Ta, Ru, Ir, Co, Pt, Au, and Ag), or metal silicide materials (e.g., silicide materials of Ti, Mo, W, Cu, Al, Ta, Ru, Ir, Co, Pt, Au, and Ag). The conductive contact 160 may be electrically connected to an impurity region (e.g., a source/drain region) formed in the substrate 100.

The capacitor structure CAP, an etch stop layer ES, and a supporting layer SS may be provided on the conductive contacts 160. The etch stop layer ES may be disposed on the interlayer insulating layer 162. The etch stop layer ES may be provided to cover the interlayer insulating layer 162 and expose the conductive contacts 160. For example, a bottom surface of the etch stop layer ES may contact a top surface of the interlayer insulating layer 162. The etch stop layer ES may be formed of or include at least one of silicon oxide, SiCN, or SiBN. In an embodiment, the capacitor structure CAP may correspond to the capacitor structure CAP of FIGS. 1A to 1C and may include the bottom electrode BE, the dielectric layer DL, and the top electrode TE.

The bottom electrode BE may be disposed on the conductive contact 160. The bottom electrode BE may penetrate the etch stop layer ES and may be electrically connected to the conductive contact 160. For example, a bottom surface of the bottom electrode BE may contact a top surface of the conductive contact 160. A lower portion of the bottom electrode BE may be enclosed by the etch stop layer ES. Here, the bottom electrode BE may be a pillar-shaped pattern.

In an embodiment, a plurality of bottom electrodes BE may be provided and may be spaced apart from each other in the first and second directions D1 and D2. When viewed in a plan view, the bottom electrodes BE may be arranged in a honeycomb shape. In detail, the bottom electrodes BE may be provided such that each of the bottom electrodes BE is placed at the center of a hexagon defined by other six bottom electrodes BE.

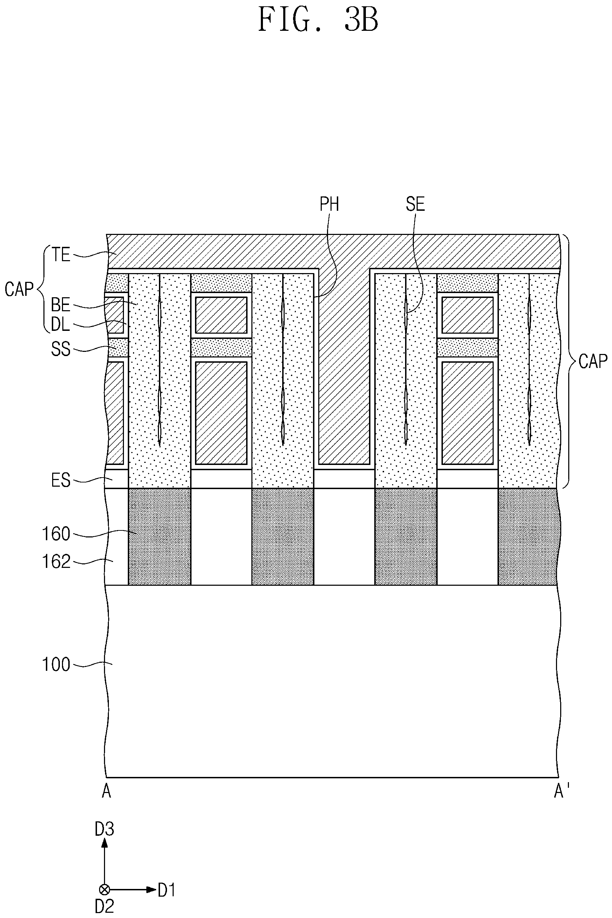

FIG. 3B is a sectional view taken along a line A-A' of FIG. 2. An element previously described with reference to FIGS. 2 and 3A may be identified by the same reference number without repeating an overlapping description thereof.

Referring to FIG. 3B, the bottom electrode BE may be a pillar-shaped pattern, in which a seam SE is formed. The seam SE may extend from a center of a top surface of the bottom electrode BE toward the top surface of the conductive contact 160. The seam SE may be longer than half of the height of the bottom electrode BE. The seam SE may not contact the top surface of the conductive contact 160.

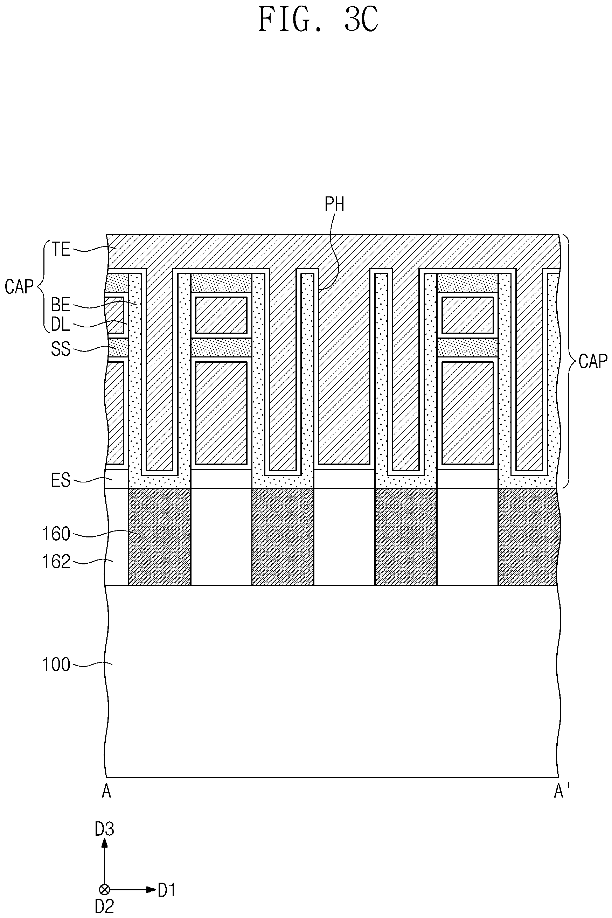

FIG. 3C is a sectional view taken along a line A-A' of FIG. 2. An element previously described with reference to FIGS. 2 and 3A may be identified by the same reference number without repeating an overlapping description thereof.

Referring to FIG. 3C, the bottom electrode BE may have a hollow cylinder shape with one closed end (e.g., a cup shape). However, the shape of the bottom electrode BE is not limited to this example.

Referring back to FIGS. 2 and 3A, the supporting layer SS may be provided on the substrate 100. The supporting layer SS may be provided between the bottom electrodes BE, which are adjacent to each other. The supporting layer SS may be in contact with a side surface of the bottom electrode BE and may enclose the side surface of the bottom electrode BE. Accordingly, the supporting layer SS may mechanically support the bottom electrode BE.

In an embodiment, the supporting layer SS may be a plurality of supporting layers SS, and the plurality of supporting layers SS may be provided to be spaced apart from each other in the third direction D3. A top surface of the uppermost one of the supporting layers SS may be located at a level that is different from or equal to the top surface of the bottom electrode BE. In an embodiment, the supporting layer SS may be formed of or include at least one of silicon nitride, SiBN, or SiCN.

A penetration hole PH may be disposed between the bottom electrodes BE, which are adjacent to each other. In an embodiment, the penetration hole PH having a circular shape may be disposed between three adjacent bottom electrodes BE to expose a portion of a side surface of each of each of the three bottom electrodes BE. However, the inventive concept is not limited to this example, and the penetration hole PH may be disposed, in various shapes, between the bottom electrodes BE. The penetration hole PH may be provided to expose the etch stop layer ES. In an embodiment, a plurality of penetration holes PH may be provided to be spaced apart from each other in the first direction D1 and the second direction D2.

The top electrode TE may be provided on the bottom electrode BE. The top electrode TE may cover the bottom electrode BE and the supporting layer SS. The top electrode TE may be provided to fill the penetration holes PH, a region between the bottom electrodes BE, a region between the supporting layers SS, and a region between the lowermost one of the supporting layers SS and the etch stop layer ES.

The dielectric layer DL may be interposed between each of the bottom electrodes BE and the top electrode TE. The dielectric layer DL may be extended into regions between the supporting layer SS and the top electrode TE and between the etch stop layer ES and the top electrode TE. The dielectric layer DL may conformally cover the supporting layer SS, the bottom electrodes BE, and the etch stop layer ES. The dielectric layer DL, along with the top electrode TE, may fill the penetration holes PH.

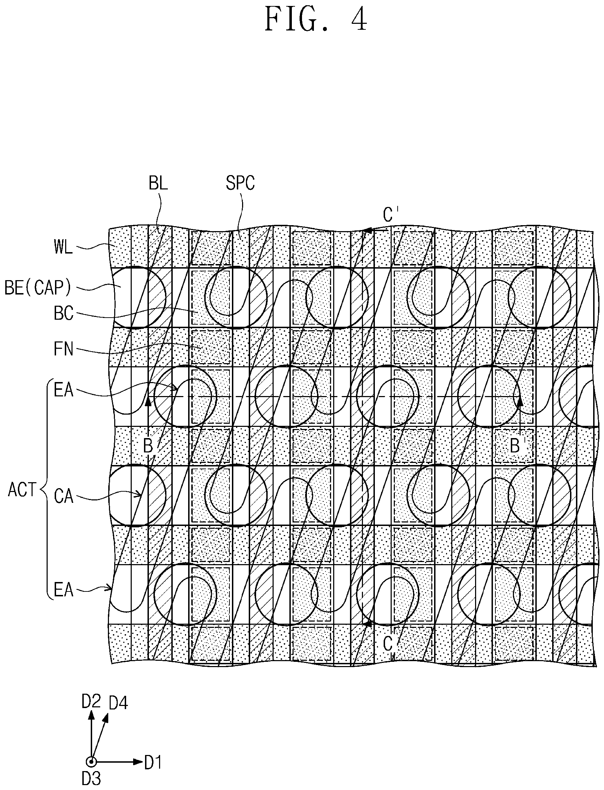

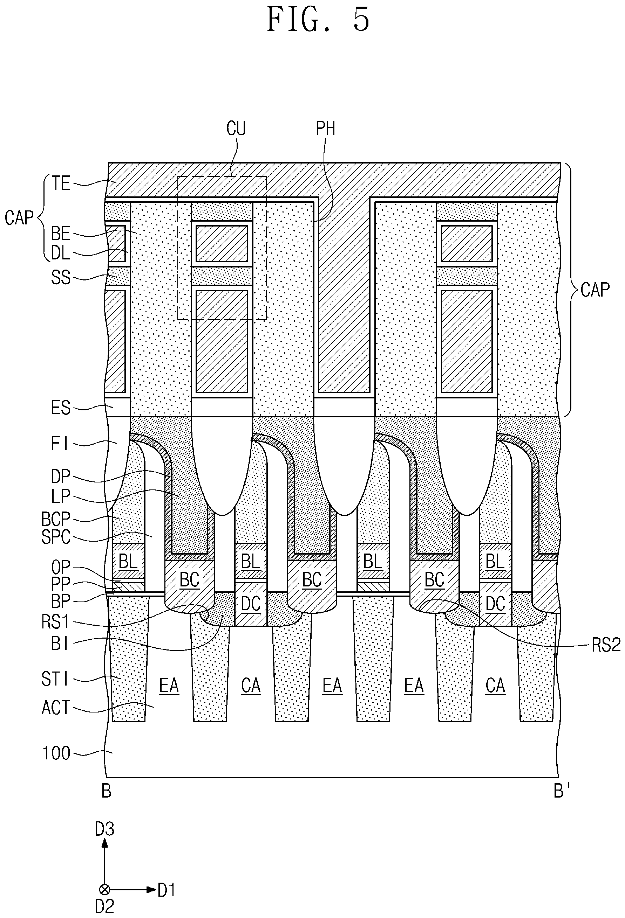

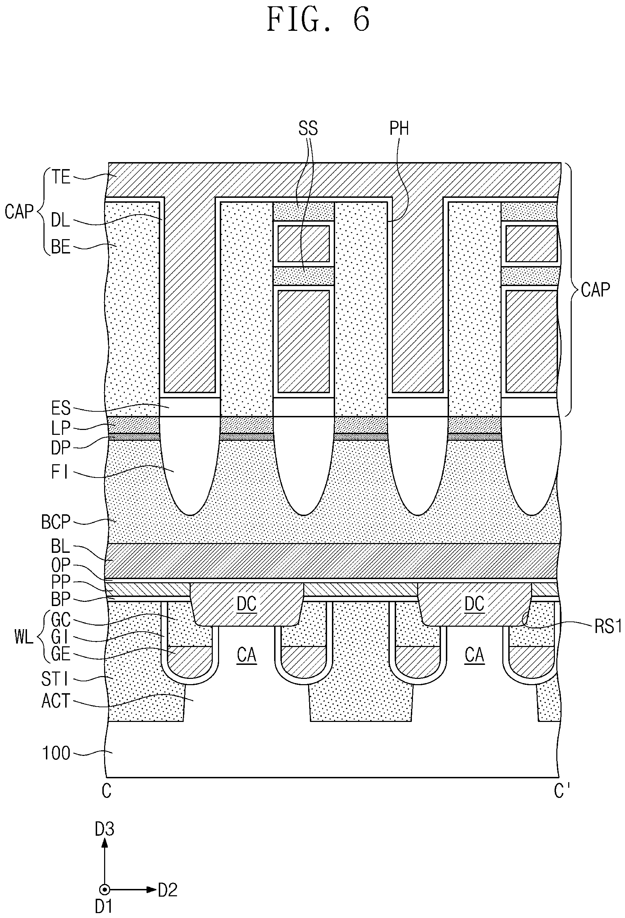

FIG. 4 is a plan view illustrating a semiconductor device according to an example embodiment of the inventive concept. FIGS. 5 and 6 are sectional views taken along lines B-B' and C-C' of FIG. 4.

Referring to FIGS. 4 to 6, the substrate 100 may be provided. The substrate 100 may correspond to the substrate 100 of FIG. 3A.

A device isolation pattern STI may be disposed on the substrate 100. The device isolation pattern STI may be provided to define active patterns ACT on the substrate 100. Each of the active patterns ACT may be a protruding portion that is extended in the third direction D3. In an embodiment, the device isolation pattern STI may be disposed in the substrate 100, and the active patterns ACT may be portions of the substrate 100 enclosed by the device isolation pattern STI. For the sake of convenience in explanation, the term "substrate 100" may refer to the remaining portion of the substrate 100, excluding the active patterns ACT, unless otherwise stated.

The active patterns ACT may be spaced apart from each other in the first and second directions D1 and D2. The active patterns ACT may be isolated bar-shaped patterns, which are spaced apart from each other and are elongated in a fourth direction D4. The fourth direction D4 may be parallel to the top surface of the substrate 100 and may not be parallel to (e.g. may intersect) the first and second directions D1 and D2.

Each of the active patterns ACT may include a pair of edge portions EA and a center portion CA. The pair of edge portions EA may be end portions of the active pattern ACT that are opposite to each other in the fourth direction D4. The center portion CA may be a portion of the active pattern ACT, which is interposed between the pair of edge portions EA, and in particular, may be a portion of the active pattern ACT, which is interposed between a pair of word lines WL to be described below. The pair of edge portions EA and the center portion CA may be impurity regions that are doped with impurities (e.g., n-type or p-type impurities).

The device isolation pattern STI may include an insulating material. As an example, the device isolation pattern STI may be formed of or include at least one of silicon oxide or silicon nitride. The device isolation pattern STI may be a single layer, which is made of one of the above materials, or a composite layer, which is made of at least two of the above materials.

The word line WL may be disposed to cross the active patterns ACT. As an example, the word line WL may be provided to cross the active patterns ACT and the device isolation pattern STI in the first direction D1. In an embodiment, a plurality of word lines WL may be provided. The word lines WL may be spaced apart from each other in the second direction D2. In an embodiment, a pair of the word lines WL, which are adjacent to each other in the second direction D2, may be provided to cross the active pattern ACT.

In an embodiment, each of the word lines WL may include a gate electrode GE, a gate insulating pattern GI, and a gate capping pattern GC. The gate electrode GE may be provided to cross the active patterns ACT and the device isolation pattern STI in the first direction D1. The gate insulating pattern GI may be interposed between the gate electrode GE and the active patterns ACT. The gate capping pattern GC may cover a top surface of the gate electrode GE.

A buffer pattern BP may be disposed on the substrate 100. The buffer pattern BP may cover the active patterns ACT, the device isolation pattern STI, and the word lines WL. The buffer pattern BP may be formed of or include at least one of silicon oxide, silicon nitride, or silicon oxynitride. The buffer pattern BP may be a single layer, which is made of a single material, or a composite layer including two or more materials.

A bit line node contact DC may be provided on each of the active patterns ACT, and in an embodiment, a plurality of bit line node contacts DC may be provided. Each of the bit line node contacts DC may be connected to a corresponding one of the center portions CA of the active patterns ACT. The bit line node contacts DC may be spaced apart from each other in the first and second directions D1 and D2. The bit line node contacts DC may be interposed between the active patterns ACT and bit lines BL, which will be described below. Each of the bit line node contacts DC may connect a corresponding one of the bit lines BL to the center portion CA of a corresponding one of the active patterns ACT. In an embodiment, the bit line node contact DC may be formed of or include doped polysilicon.

The bit line node contacts DC may be disposed in first recess regions RS1, respectively. The first recess regions RS1 may be provided in upper portions of the active patterns ACT and the device isolation pattern STI, which are adjacent to each other. The first recess regions RS1 may be spaced apart from each other in the first and second directions D1 and D2.

A gapfill insulating pattern BI may fill each of the first recess regions RS1. The gapfill insulating pattern BI may fill an inner space of the first recess region RS1. In an embodiment, the gapfill insulating pattern BI may cover an inner surface of the first recess region RS1 and at least a portion of a side surface of the bit line node contact DC (e.g., in the first recess region RS1). The gapfill insulating pattern BI may be formed of or include at least one of silicon oxide or silicon nitride. The gapfill insulating pattern BI may be a single layer, which is made of a single material, or a composite layer including two or more materials.

The bit line BL may be provided on the bit line node contact DC. The bit line BL may be disposed on the bit line node contacts DC, which are linearly arranged in the second direction D2. In an embodiment, a plurality of bit lines BL may be provided. The bit lines BL may be spaced apart from each other in the first direction D1. The bit lines BL may include a metallic material. The bit lines BL may be formed of or include at least one of metallic materials (e.g., Ti, Mo, W, Cu, Al, Ta, Ru, Ir, Co, Pt, Au, and Ag).

A polysilicon pattern PP may be interposed between the bit line BL and the buffer pattern BP. A top surface of the polysilicon pattern PP may be located at substantially the same height as a top surface of the bit line node contact DC. The polysilicon pattern PP may be formed of or include doped polysilicon.

An ohmic pattern OP may be interposed between the bit line BL and the bit line node contact DC and between the bit line BL and the polysilicon pattern PP. The ohmic pattern OP may be formed of or include at least one of metal silicide materials (e.g., silicide materials containing Ti, Mo, W, Cu, Al, Ta, Ru, Ir, Co, Pt, Au, and Ag). A barrier pattern (not shown) may be further interposed between the bit line BL and the bit line node contact DC and between the bit line BL and the polysilicon pattern PP. The barrier pattern may be formed of or include at least one of conductive metal nitride materials (e.g., nitride materials containing Ti, Mo, W, Cu, Al, Ta, Ru, Ir, Co, Pt, Au, and Ag).

A bit line capping pattern BCP may be provided on the bit line BL. In an embodiment, the bit line capping patterns BCP may be provided on the top surfaces of the bit lines BL, respectively. In an embodiment, the bit line capping patterns BCP may be extended along corresponding ones of the bit lines BL or in the second direction D2 and may be spaced apart from each other in the first direction D1. Each of the bit line capping patterns BCP may be vertically overlapped with a corresponding one of the bit lines BL. The bit line capping pattern BCP may be composed of a single layer or a plurality of layers. As an example, the bit line capping pattern BCP may include first, second, and third capping patterns (not shown), which are sequentially stacked. In an embodiment, each of the first to third capping patterns may include silicon nitride. As another example, the bit line capping pattern BCP may further include additional capping patterns (e.g., fourth and fifth capping patterns) (not shown).

A bit line spacer SPC may be provided on a side surface of the bit line BL and a side surface of the bit line capping pattern BCP. The bit line spacer SPC may cover the side surface of the bit line BL and the side surface of the bit line capping pattern BCP. The bit line spacer SPC on the side surface of the bit line BL may be extended in the second direction D2.

Each of the bit line spacers SPC may include a plurality of sub-spacers. In an embodiment, each of the bit line spacers SPC may include three or more sub-spacers, which are sequentially provided on the side surface of the bit line BL. Each of the sub-spacers may independently include at least one of silicon nitride, silicon oxide, or silicon oxynitride. In an embodiment, at least one of the sub-spacers may include an air gap that is formed to separate the others of the sub-spacers from each other.

A storage node contact BC may be provided between adjacent ones of the bit lines BL. In an embodiment, a plurality of storage node contacts BC may be provided to be spaced apart from each other in the first and second directions D1 and D2. The storage node contact BC may fill a second recess region RS2, which is formed on the edge portion EA of the active pattern ACT. The storage node contact BC may be electrically connected to the edge portion EA. The storage node contact BC may include a conductive material. In an embodiment, the storage node contact BC may be formed of or include at least one of doped polysilicon or metallic materials (e.g., Ti, Mo, W, Cu, Al, Ta, Ru, Ir, Co, Pt, Au, and Ag).

On the word lines WL, fence patterns FN may separate the storage node contacts BC from each other in the second direction D2. In an embodiment, the fence patterns FN may be spaced apart from each other in the second direction D2 with the storage node contacts BC interposed therebetween. In an embodiment, the fence patterns FN may be formed of or include silicon nitride.

A diffusion barrier layer DP may conformally cover the storage node contact BC and the bit line spacer SPC. The diffusion barrier layer DP may be formed of or include a conductive metal nitride material (e.g., containing at least one of Ti, Mo, W, Cu, Al, Ta, Ru, Ir, Co, Pt, Au, or Ag). A metal silicide layer may be further interposed between the diffusion barrier layer DP and the storage node contact BC.

A landing pad LP may be provided on the storage node contact BC. In an embodiment, a plurality of landing pads LP may be provided and may be spaced apart from each other in the first and second directions D1 and D2. Each of the landing pads LP may be connected to a corresponding one of the storage node contacts BC. The landing pad LP may cover a top surface of the bit line capping pattern BCP. In an embodiment, a lower portion of the landing pad LP may be vertically overlapped with the storage node contact BC, and an upper portion of the landing pad LP may be shifted from the lower portion in the second direction D2 or an opposite direction thereof. The landing pad LP may be formed of or include at least one of metallic materials (e.g., Ti, Mo, W, Cu, Al, Ta, Ru, Ir, Co, Pt, Au, and Ag).

A filler pattern FI may be provided to enclose the landing pad LP. The filler pattern FI may be interposed between the landing pads LP, which are adjacent to each other. When viewed in a plan view, the filler pattern FI may be provided in a mesh shape with holes, and in this case, the landing pads LP may be provided in the holes to penetrate the filler pattern FI. The filler pattern FI may be formed of or include at least one of silicon nitride, silicon oxide, or silicon oxynitride. Alternatively, the filler pattern FI may include an empty space with an air layer (e.g., an air gap). As used herein, the term "air" may refer to atmospheric air, or other gases that may be present during the manufacturing process.

The capacitor structure CAP, the etch stop layer ES, and the supporting layer SS may be provided on the conductive contacts 160. The capacitor structure CAP, the etch stop layer ES, and the supporting layer SS may correspond to the capacitor structure CAP, the etch stop layer ES, and the supporting layer SS in the embodiment of FIGS. 2 and 3A to 3C. Thus, the capacitor structure CAP, the etch stop layer ES, and the supporting layer SS of FIGS. 4 to 6 may have substantially the same or similar features as the capacitor structure CAP, the etch stop layer ES, and the supporting layer SS described with reference to FIGS. 2 and 3A to 3C.

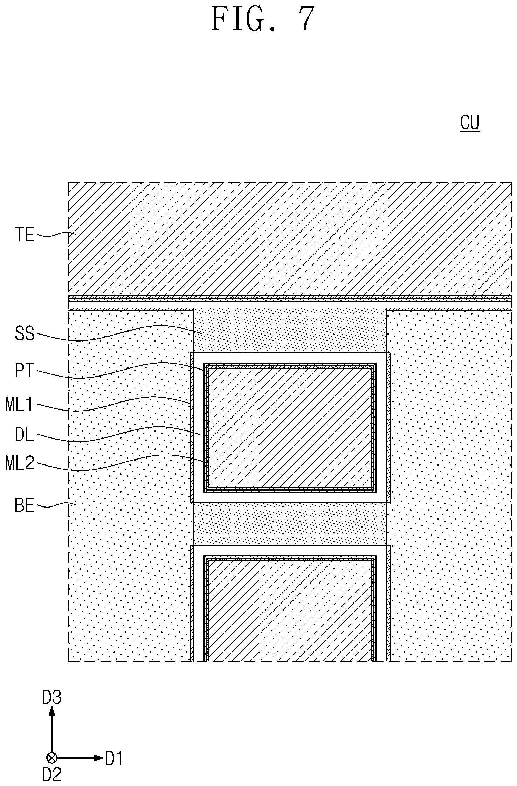

FIG. 7 is an enlarged sectional view illustrating a portion (e.g., CU of FIG. 5) of the semiconductor device according to an example embodiment of the inventive concept. In detail, FIG. 7 is an enlarged view illustrating a portion of the semiconductor device, to which the capacitor structure CAP of FIG. 1C is applied.

Referring to FIG. 7, the first material layer ML1 may be provided on the bottom electrode BE. The second material layer ML2 may be provided on the top electrode TE. Here, a concentration of the metal material layer in the first material layer MI,1 may range from 0 at% to 30 at%.

The first material layer MI,1 on the bottom electrode BE may not be extended to the supporting layer SS. That is, the first material layer MI,1 may not be provided on the supporting layer SS. FIG. 7 illustrates the first material layer ML1, which is provided on the bottom electrode BE, but the inventive concept is not limited to this example. In an embodiment, the oxide layer BEO, instead of the first material layer ML1, may be interposed between the bottom electrode BE and the dielectric layer DL, as shown in FIG. 1B.

The capping layer PT may be interposed between the dielectric layer DL and the second material layer ML2. FIG. 7 illustrates the capping layer PT, which is interposed between the dielectric layer DL and the second material layer ML2, but the inventive concept is not limited to this example. In the case where, as shown in FIG. 1A, the second material layer ML2 is absent, the capping layer PT may be interposed between the top electrode TE and the dielectric layer DL, although not shown.

According to an embodiment of the inventive concept, the dielectric layer of the capacitor structure of the semiconductor device may include a first metal oxide layer and a third metal oxide layer containing zirconium oxide and a second metal oxide layer containing hafnium-zirconium oxide. Here, a concentration of zirconium in the second metal oxide layer may range from 20 at% to 80 at %. In other words, since the second metal oxide layer includes both of tetragonal and orthorhombic crystal phases, a morphotropic phase boundary (MPB) phenomenon may occur. As a result, the capacitor structure may have improved capacitance characteristics and a reduced leakage current, and this may make it possible to improve the electrical characteristics of the semiconductor device.

In addition, the capacitor structure may include a material layer containing tantalum. Due to the material layer, the MPB phenomenon may be induced in the second metal oxide layer in the dielectric layer, and in this case, the electrical characteristics of the capacitor structure may be improved.

According to an embodiment of the inventive concept, a semiconductor device may include a capacitor structure. A dielectric layer of the capacitor structure may have a region having both of tetragonal and orthorhombic crystal phases, and in this case, a morphotropic phase boundary (MPB) phenomenon may occur. This can increase the permittivity of the dielectric layer. As a result, the capacitor structure may have improved capacitance characteristics and a reduced leakage current, and this may make it possible to improve the electrical characteristics of the semiconductor device.

Embodiments are set out in the following Clauses:
Clause 1. A semiconductor device, comprising:
   a bottom electrode;
   a top electrode on the bottom electrode; and
   a dielectric layer and a material layer interposed between the bottom electrode and the top electrode,
   wherein the dielectric layer comprises:
      a first metal oxide layer;
      a second metal oxide layer on the first metal oxide layer; and
      a third metal oxide layer interposed between the first and second metal oxide layers,
   wherein the first and second metal oxide layers comprises zirconium oxide,
   wherein the third metal oxide layer comprises hafnium-zirconium oxide, and
   wherein a thickness of the third metal oxide layer is 30 % to 50 % of a thickness of the dielectric layer.
Clause 2. The semiconductor device of Clause 1,
   wherein the thickness of the dielectric layer ranges from 20 Å to 80 Å, and
   wherein the thickness of the third metal oxide layer ranges from 6 Å to 40 Å.
Clause 3. The semiconductor device of Clause 1 or Clause 2, wherein the bottom electrode has a pillar shape or a cylinder shape.
Clause 4. The semiconductor device of any preceding Clause,
   wherein the material layer comprises a first material layer and a second material layer,
   wherein the first material layer is in contact with the bottom electrode,
   wherein the second material layer is in contact with the top electrode, and
   wherein a thickness of each of the first and second material layers ranges from 1 Å to 5 Å.
Clause 5. A semiconductor device, comprising:
   a sub strate;
   conductive contacts on the substrate;
   bottom electrodes on the conductive contacts;
   a top electrode on the bottom electrodes; and
   a dielectric layer and a material layer between the bottom electrodes and the top electrode,
   wherein the dielectric layer comprises:
      a first metal oxide layer;
      a second metal oxide layer on the first metal oxide layer; and
      a third metal oxide layer on the second metal oxide layer,
   wherein the first and third metal oxide layers comprise zirconium oxide,
   wherein the second metal oxide layer comprises hafnium-zirconium oxide,
   wherein the material layer comprises one of a metal material containing a metal element, an oxide material containing the metal element, and an oxynitride material containing the metal element,
   wherein the metal element comprises at least one of scandium (Sc), yttrium (Y), titanium (Ti), vanadium (V), niobium (Nb), tantalum (Ta), chromium (Cr), molybdenum (Mo), tungsten (W), iron (Fe), ruthenium (Ru), osmium (Os), cobalt (Co), rhodium (Rh), iridium (Ir), boron (B), tin (Sn), platinum (Pt), and lanthanum (La),
   wherein the first and third metal oxide layers comprise a tetragonal crystal phase, and
   wherein the second metal oxide layer comprises the tetragonal crystal phase and an orthorhombic crystal phase.
Clause 6. The semiconductor device of Clause 5,
   wherein the material layer is interposed between the dielectric layer and the top electrode, and
   wherein a thickness of the material layer ranges from 1 Å to 5 Å.
Clause 7. The semiconductor device of Clause 5 or Clause 6, further comprising:
   a supporting layer between the bottom electrodes; and
   a capping layer interposed between the dielectric layer and the material layer.
Clause 8. The semiconductor device of Clause 7, wherein the capping layer comprises at least one of silicon (Si), boron (B), lithium (Li), scandium (Sc), aluminum (Al), yttrium (Y), niobium (Nb), tantalum (Ta), titanium (Ti), molybdenum (Mo), and lanthanum (La).
Clause 9. The semiconductor device of any of Clauses 5-8, wherein a concentration of zirconium in the second metal oxide layer of the dielectric layer is higher than a concentration of hafnium.
Clause 10. The semiconductor device of any of Clauses 5-9, wherein a concentration of the metal material in the material layer ranges from 0 at% to 30 at%.
Clause 11. The semiconductor device of any of Clauses 5-10,
   wherein a thickness of the dielectric layer ranges from 20 Å to 80 Å, and
   wherein a thickness of the second metal oxide layer ranges from 6 Å to 40 Å.

While example embodiments of the inventive concept have been particularly shown and described, it will be understood by one of ordinary skill in the art that variations in form and detail may be made therein without departing from the scope of the attached claims.

## Claims

1. A semiconductor device, comprising:
a bottom electrode;
a top electrode on the bottom electrode; and
a dielectric layer and a material layer interposed between the bottom electrode and the top electrode,
wherein the dielectric layer comprises:
a first metal oxide layer;
a second metal oxide layer on the first metal oxide layer; and
a third metal oxide layer interposed between the first and second metal oxide layers,
wherein the material layer comprises one or more of a metal material containing a metal element, an oxide material containing the metal element, and an oxynitride material containing the metal element, and
wherein the metal element comprises at least one of scandium, yttrium, titanium, vanadium, niobium, tantalum, chromium, molybdenum, tungsten, iron, ruthenium, osmium, cobalt, rhodium, iridium, boron, tin, platinum, and lanthanum,
wherein the third metal oxide layer comprises a compound represented by the following chemical formula 1:
[Chemical formula 1] AₓB₁₋ₓ O₂,
where A and B are two different elements, which are chosen from the group consisting of zirconium, hafnium, titanium, niobium, tantalum, strontium, and barium, and
where 0 < x < 1 and
wherein the third metal oxide layer comprises the tetragonal crystal phase and an orthorhombic crystal phase.

2. The semiconductor device of claim 1,
wherein the chemical formula 1 is given by HfₓZr₁₋ₓO₂, and
wherein the first and second metal oxide layers comprise zirconium oxide.

3. The semiconductor device of claim 2, wherein a concentration of zirconium in the third metal oxide layer of the dielectric layer is higher than a concentration of hafnium.

4. The semiconductor device of any preceding claim, wherein a concentration of the element A in the third metal oxide layer ranges from 20 at% to 80 at %.

5. The semiconductor device of any preceding claim, wherein a concentration of the metal material in the material layer ranges from 0 at% to 30 at%.

6. The semiconductor device of any preceding claim, wherein the first and second metal oxide layers comprise zirconium oxide that is doped with at least one of aluminum, yttrium, vanadium, or silicon.

7. The semiconductor device of any preceding claim, wherein each of the bottom and top electrodes comprises at least one of vanadium nitride, titanium nitride, niobium nitride, molybdenum nitride, tantalum nitride, ruthenium, ruthenium oxide, platinum, iridium, strontium ruthenate, tungsten, or tungsten nitride.

8. The semiconductor device of any preceding claim,
wherein the material layer is interposed between the top electrode and the dielectric layer,
wherein the semiconductor device further comprises an oxide layer interposed between the bottom electrode and the dielectric layer, and
wherein the oxide layer comprises an oxide material that contains a material included in the bottom electrode.

9. The semiconductor device of any preceding claim,
wherein the material layer comprises:
a first material layer interposed between the bottom electrode and the dielectric layer; and
a second material layer interposed between the top electrode and the dielectric layer,
wherein the first material layer is in contact with the first metal oxide layer of the dielectric layer, and
wherein the second material layer is in contact with the second metal oxide layer of the dielectric layer.

10. The semiconductor device of claim 9, wherein the first material layer comprises an oxide material that contains a material included in the bottom electrode.

11. The semiconductor device of any preceding claim, wherein a thickness of the third metal oxide layer is 30 % to 50 % of a thickness of the dielectric layer.

12. The semiconductor device of any preceding claim, wherein the thickness of the dielectric layer ranges from 20 Å to 80 Å, and
wherein the thickness of the third metal oxide layer ranges from 6 Å to 40 Å.

13. The semiconductor device of any preceding claim, wherein the first and second metal oxide layers comprise a tetragonal crystal phase.

14. The semiconductor device of any preceding claim, further comprising a capping layer interposed between the dielectric layer and the material layer.

15. The semiconductor device of claim 14, wherein the capping layer comprises at least one of silicon, boron, lithium, scandium, aluminum, yttrium, niobium, tantalum, titanium, molybdenum, and lanthanum.
